# EUROPEAN PATENT SPECIFICATION

(11) **EP 2 036 955 B1**
(45) Date of publication and mention of the grant of the patent: **16.05.2012**
(21) Application number: 07116557.5
(22) Date of filing: 17.09.2007
(51) Int. Cl.: C09B 57/10, H01G 9/20, C07F 15/00, H01L 51/00

(54) **DYESTUFF, DYE-SENSITIZED SOLAR CELL, AND METHOD FOR MANUFACTURING SAME**
FARBSTOFF, FARBSTOFFSENSIBILISIERTE SOLARZELLE UND HERSTELLUNGSVERFAHREN DAFÜR
COLORANTS, PILE SOLAIRE SENSIBILISÉE AUX COLORANTS ET SON PROCÉDÉ DE FABRICATION

(43) Date of publication of application: 18.03.2009
(73) Proprietor: JSR Corporation, Tokyo 104-8410 (JP); EPFL Ecole Polytechnique Fédérale de Lausanne, 1015 Lausanne (CH)
(72) Inventor: Yoneda, Eiji, Tokyo 104-8410 (JP); Grätzel, Michael, 1015 Lausanne (CH); Nazeeruddin, Md. Khaja, 1015 Lausanne (CH)
(74) Representative: TBK

(56) References cited:
- EP-A- 1 176 618
- EP-A- 1 622 178
- WO-A-95/29924
- WO-A-2006/100888
- DE-A1-102005 010 978
- US-A1- 2005 033 040
- US-A1- 2006 115 675
- US-A1- 2007 141 398
- DATABASE WPI Week 200737 Thomson Scientific, London, GB; AN 2007-392907 XP002496116 -& JP 2007 073289 A (FUJI FILM CO LTD) 22 March 2007 (2007-03-22)
- DATABASE WPI Week 200504 Thomson Scientific, London, GB; AN 2005-033390 XP002496117 -& JP 2004 296170 A (MITSUI CHEM INC) 21 October 2004 (2004-10-21)

## Description

### BACKGROUND OF THE INVENTION

### Field of the Invention

The present invention relates to a dyestuff, a dye-sensitized solar cell, and a method for manufacturing the same.

### Description of Related Art

Along with an increased concern about energy problems, extensive efforts are being directed to research on solar cells which can efficiently convert light, particularly sunlight, into electricity. For example, silicon-based solar cells using amorphous silicon or polycrystalline silicon are being widely accepted.

However, widespread use of the silicon-based solar cells is expected to be limited because of high production cost and difficulty in making a large amount of high purity silicon available at low cost.

For this reason, a dye-sensitized solar cell is attracting attention in recent years. The dye-sensitized solar cell has many advantages over silicon-based solar cells such as a high power generation efficiency, comparatively low manufacturing cost, abundant availability of inexpensive oxide semiconductors such as titanium oxide as raw materials which need not be purified, low investment cost for equipment used for manufacturing, and the like. Therefore, the dye-sensitized solar cell is expected to be the next-generation solar cell (see, for example, Patent Documents 1 and 2).

The dye-sensitized solar cell is equipped with an anode, a cathode, and an electrolyte as in other common cells. The cathode has a substrate made of electrically conductive transparent glass, with an oxide membrane electrode formed on the surface. The oxide membrane electrode contains a specific dye adsorbed therein.

As the dye adsorbed in the oxide membrane electrode, a dye "N719" shown by the following formula (10) or "Black Dye" shown by the following formula (11) are known (see, for example, Non-patent Documents 1 and 2). 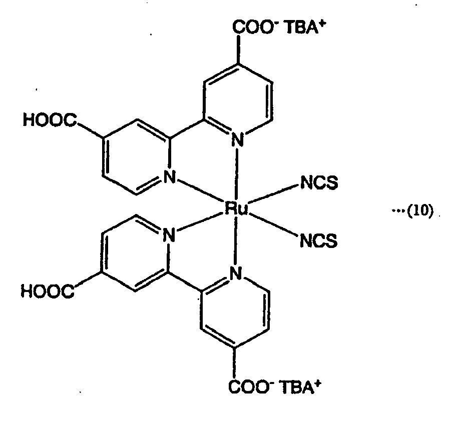 wherein TBA⁺ indicates a tetrabutylammonium ion, and 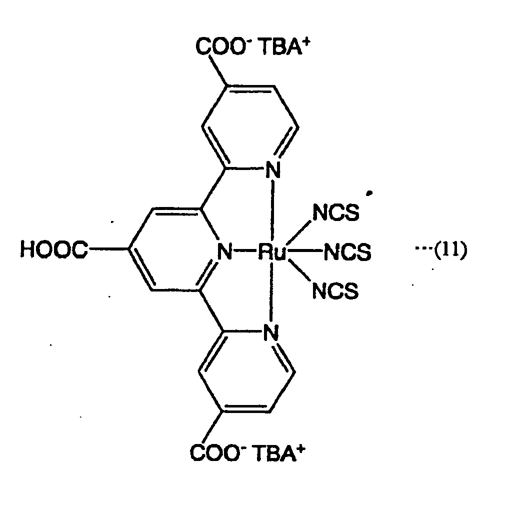 wherein TBA⁺ indicates a tetrabutylammonium ion.

(Patent Document 1) USP 4927721
(Patent Document 2) WO 98/50393
(Non-patent Document 1) J. Am. Chem. Soc., 115, 6382-6390 (1993)
(Non-patent Document 2) J. Am. Chem. Soc., 123, 1613-1624 (2001)

US 2006115675 (A1) relates to a metal-complex compound which comprises a tridentate chelate ligand having a specified partial structure and an organic electroluminescence device which comprises at least one organic thin film layer sandwiched between a pair of electrode consisting of an anode and a cathode, wherein the organic thin film layer comprises the metal-complex compound.

US 2007141398 (A1) provides an organic electroluminescence device and a metal complex compound for realizing the device. The metal complex compound is of a specific structure having a partial structure including a tridentate ligand. In the organic electroluminescence device, at least one layer of the organic thin film layer contains the metal complex compound.

WO 2006100888 (A1) relates to a material for organic EL devices. The organic EL material is composed of a metal complex having a partial structure represented by the general formula (1) below, and is characterized by having at least one substituent in a ligand part which suppresses bidentate coordination.

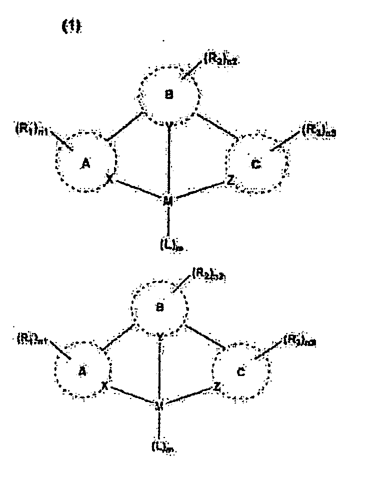

JP 2007073289 (A) provides a dye-sensitized photoelectric conversion element using new metal complex dye with stability against heat and light and excellent photoelectric conversion efficiency. The photoelectric conversion element contains semiconductor particles sensitized by metal complex dye containing a ligand that can be configured at not less than five loci, expressed in general formula (1).

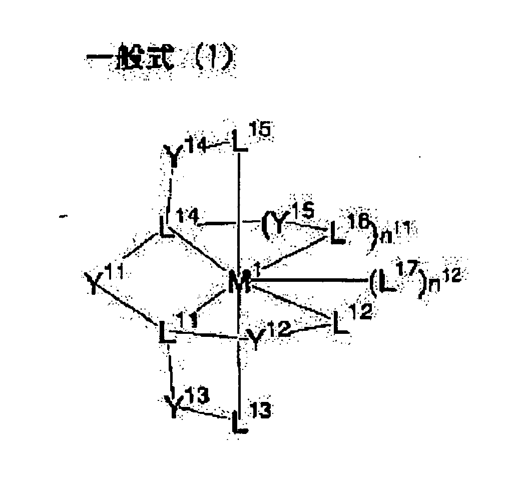

DE-A-10 2005 010 978 describes an organic photoactive device, especially an organic photovoltaic cell, comprising a sequence of organic thin films and an exciton harvesting layer (EHL).

WO 9529924 (A1) describes a compound, in metal-free or metal complex form of formula (1) to (3) in which R is hydrogen or C1-30 alkyl; X is hydrogen, halogen (preferably Cl or Br) or C1-30 alkyl.

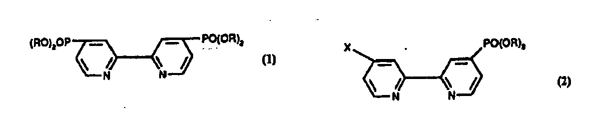

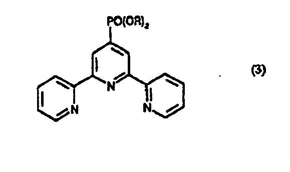

JP 2004296170 (A) provides a material for photoelectric transfer element. The material for the photoelectric transfer element comprises a metal complex compound containing a ligand as expressed by a general formula (1).

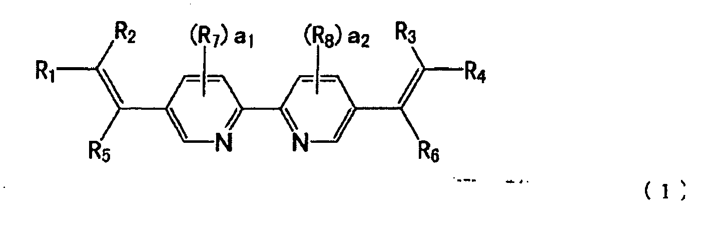

EP 1176618 (A1) describes a photoelectric conversion device comprising a semiconductor fine particle sensitized by a metal complex dye. The metal complex dye comprises a ligand represented by the following general formula (I).

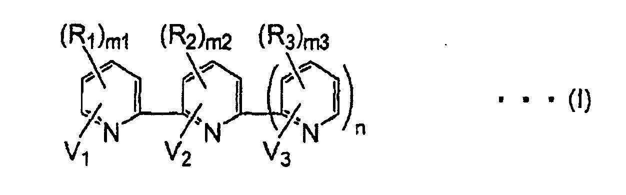

EP 1622178 (A1) describes a dye sensitized solar cell, comprising a heteroleptic polypyridil complex of Ru, Os or Fe. The donating ligand has an extended conjugated π-system. Exemplary is shown the complex of Fig. 13.

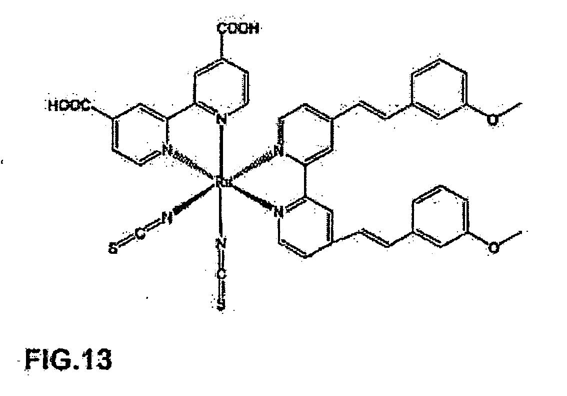

### SUMMARY OF THE INVENTION

Although the above dye-sensitized solar cells, particularly the dye-sensitized solar cell using the dye N719, exhibit high conversion efficiency but the main drawbacks of this sensitizer are the location of the absorption maximum around 535 nm, and the presence of monodentate ligands such as NCS, which raises the issue of sensitizer's stability. Dye-sensitized solar cells that can exhibit high conversion efficiency and satisfactory durability (weather resistance, heat resistance, etc.) have not been disclosed. There has been a strong demand for development of a dye-sensitized solar cell having high conversion efficiency and excellent durability (weather resistance, heat resistance, etc.).

The present invention has been achieved in view of such a technological problem in the present state of art and has an object of providing a dye-sensitized solar cell having high conversion efficiency and excellent durability in terms of weather resistance, heat resistance, and the like, a dyestuff used as a material for the dye-sensitized solar cell, and a method for manufacturing of the dye-sensitized solar cell.

As a result of extensive studies, the inventors of the present invention have found that the above object can be achieved by a dyestuff having a ligand with a specific structure. Specifically, the present invention provides the following dyestuff, dye-sensitized solar cell, and method for manufacturing the same.

[1] A dyestuff shown by the following formula (1),

   ML¹L²L³ (1)

   wherein M represents an element belonging to Group 8 to Group 10 of the long-format Periodic Table, L¹ and L² individually represent a bidentate ligand shown by the following formula (2), and L³ represents a bidentate ligand shown by the following formula (3), 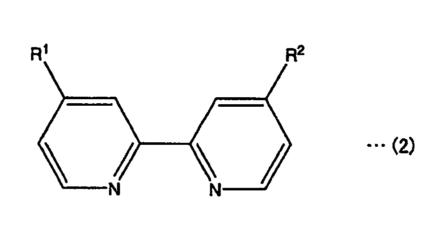 wherein R¹ and R² individually represent a monovalent organic group, and 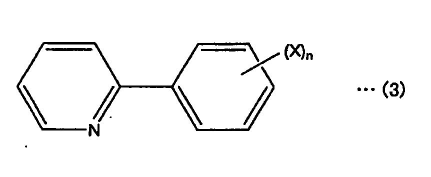 wherein X represents a halogen atom and n is an integer of 0 to 2.

[2] A dyestuff shown by the following formula (4),

   ML⁴L⁵ (4)

   wherein M represents an element belonging to Group 8 to Group 10 of the long-format Periodic Table, L⁴ represents a tridentate ligand shown by the following formula (5), and L⁵ represents a tridentate ligand shown by the following formula (6), (7), or (8), 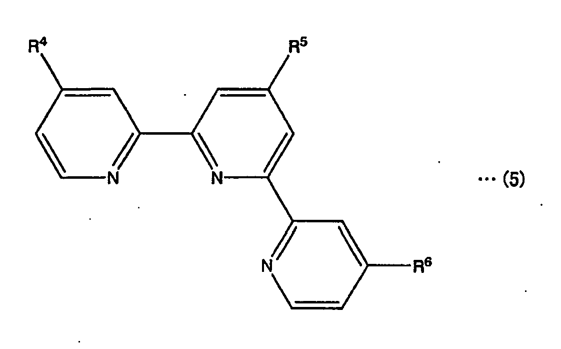 wherein R⁴, R⁵, and R⁶ individually represent a carboxyl group, a group equivalent to the salt of the carboxyl group, or a carboxyalkyl group, 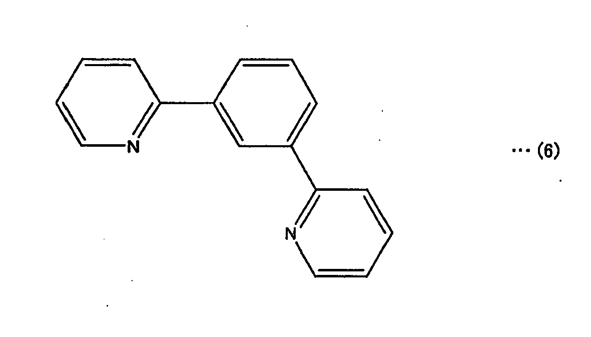 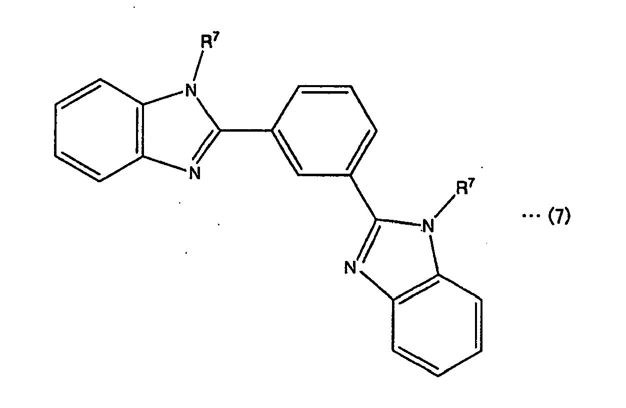 wherein R⁷ individually represents a hydrocarbon group having 1 to 8 carbon atoms,

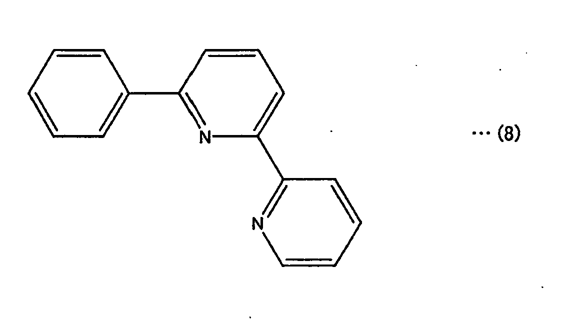

[3] A dyestuff shown by the following formula (9),

   ML³L⁴A¹ (9)

   wherein M represents an element belonging to Group 8 to Group 10 of the long-format Periodic Table, L³ represents a bidentate ligand shown by the following formula (3), L⁴ represents a tridentate ligand shown by the following formula (5), and A¹ is an isothiocyanate group, 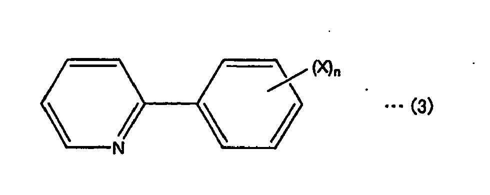 wherein X represents a halogen atom and n is an integer of 0 to 2, and 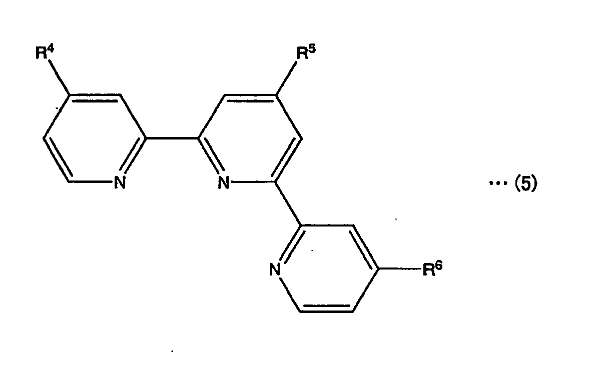 wherein R⁴, R⁵, and R⁶ individually represent a carboxyl group, a group equivalent to the salt of the carboxyl group, or a carboxyalkyl group.

[4] The dyestuff according to any one of [1] to [3] above, wherein M in the formula (1), (4) or (9) is ruthenium.

[5] A dye-sensitized solar cell comprising an anode, a cathode, and an electrolyte, the cathode having a substrate made of electrically conductive transparent glass and an oxide membrane electrode formed on the surface, and the oxide membrane electrode containing a dye according to any one of [1] to [4] above adsorbed therein.

[6] A method for manufacturing a dye-sensitized solar cell comprising causing a substrate made of electrically conductive transparent glass and a cathode having an oxide membrane electrode formed on the surface to come in contact with a dyestuff solution which contains a dyestuff according to any one of [1] to [4] above and a base, thereby causing the dyestuff to be adsorbed in the oxide membrane electrode.

[7] The method for manufacturing a dye-sensitized solar cell according to [6] above, wherein the dyestuff solution contains the base at a concentration of 0.001 to 20 mmol/l.

The dye-sensitized solar cell of the present invention exhibits high conversion efficiency and has excellent durability such as excellent weather resistance and heat resistance. The dyestuff, and the method for manufacturing, of the dye-sensitized solar cell can be suitably used for manufacturing the dye-sensitized solar cell.

### DETAILED DESCRIPTION OF THE INVENTION AND PREFERRED EMBODIMENTS

The present invention will be described by way of embodiments, which should not be construed as limiting the present invention. It should be understood that various modifications and improvements may be made within the scope of the present invention based on knowledge of a person skilled in the art.

### [1] Dyestuff:

The dyestuff of the present invention is any one of dyestuffs shown by the following formula (1), (4), or (9).

### [1-1] First embodiment:

A first embodiment of the present invention is a dyestuff shown by the following formula (1) (hereinafter referred to from time to time as "first dyestuffs"),

ML¹L²L³ (1)

In the formula (1), M is a central atom and represents a metal atom belonging to Group 8 to Group 10 of the long-format Periodic Table. As the metal atom belonging to Group 8 to Group 10, iron, ruthenium, and osmium of Group 8, cobalt, rhodium, and iridium of Group 9, and nickel, palladium, and platinum of Group 10 can be given. A dyestuff having a ruthenium atom as M is particularly preferable.

In the formula (1), L¹ and L² individually represent a bidentate ligand shown by the following formula (2),

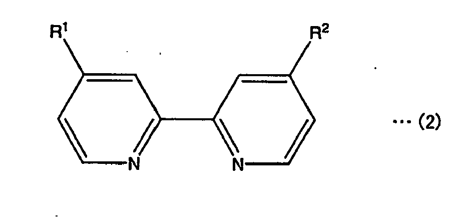

wherein R¹ and R² individually represent a monovalent organic group.

As examples of the monovalent organic group, a carboxyl group and a group equivalent to the salt of the carboxyl group can be given. As an example of the group equivalent to the salt of the carboxyl group, a group equivalent to the tetrabutylammonium salt of carboxylic acid can be given.

As an example of such a monovalent organic group, the group shown by the following formula (12) can be given.

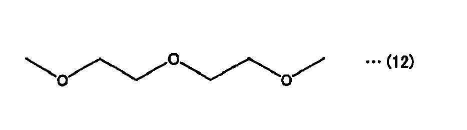

As another example of such a monovalent organic group, the group shown by the following formula (13) can be given.

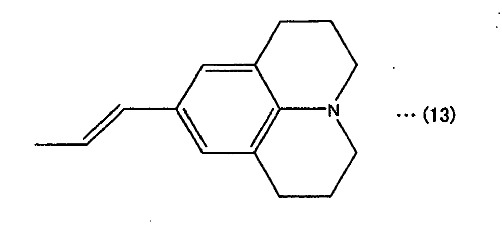

As a further example of such a monovalent organic group, the group shown by the following formula (14) can be given,

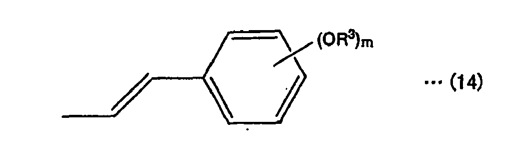

wherein R³ individually represents a methyl group or a t-butyl group, and m is an integer of 1 or 2. As specific examples, the monovalent organic group shown by the following formula (14a) and (14b) can be given.

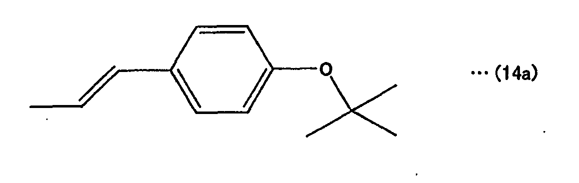

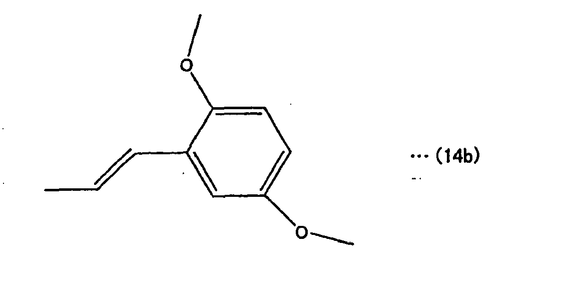

In the formula (1), L³ is a bidentate ligand shown by the following formula (3),

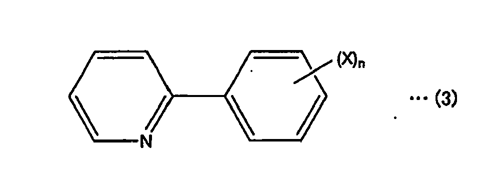

wherein X represents a halogen atom and n is an integer of 0 to 2. As specific examples, 2-phenylpyridine (following formula (3a)), 2-(2,4-difluorophenyl)pyridine, 2-(2,4-dichlorophenyl)pyridine, and 2-(2,4-dibromophenyl)pyridine (all shown by the following formula (3b)) can be given.

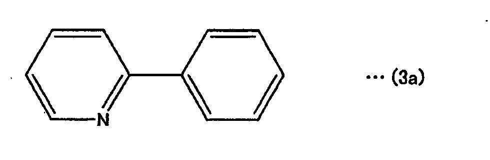

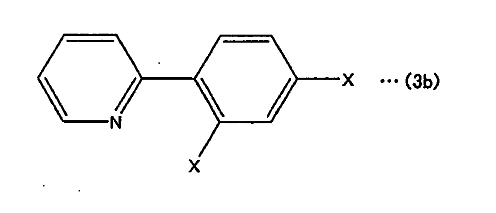

As specific examples of the dyestuff of the first embodiment, dyestuffs shown by the following formulas (1a) to (1e) can be given.

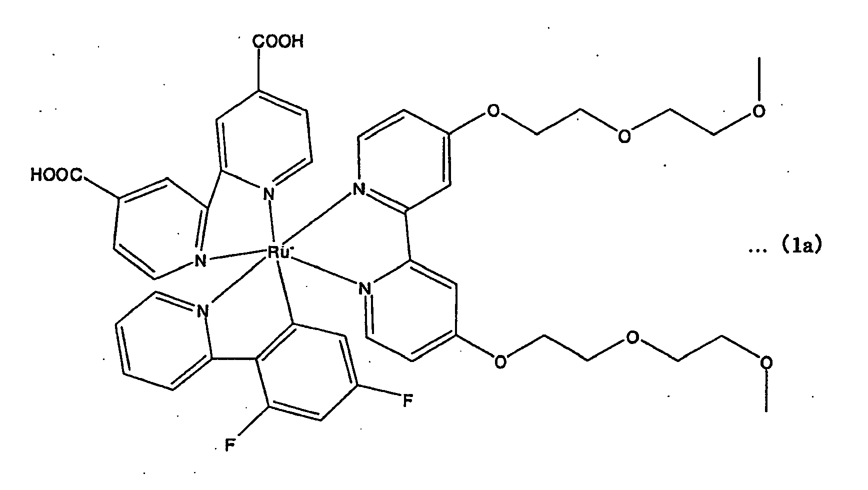

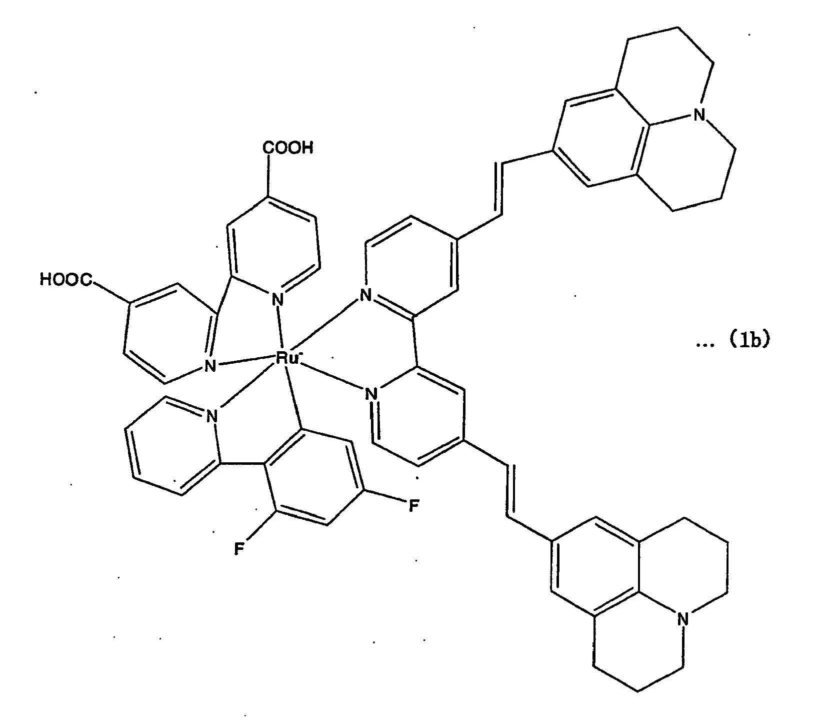

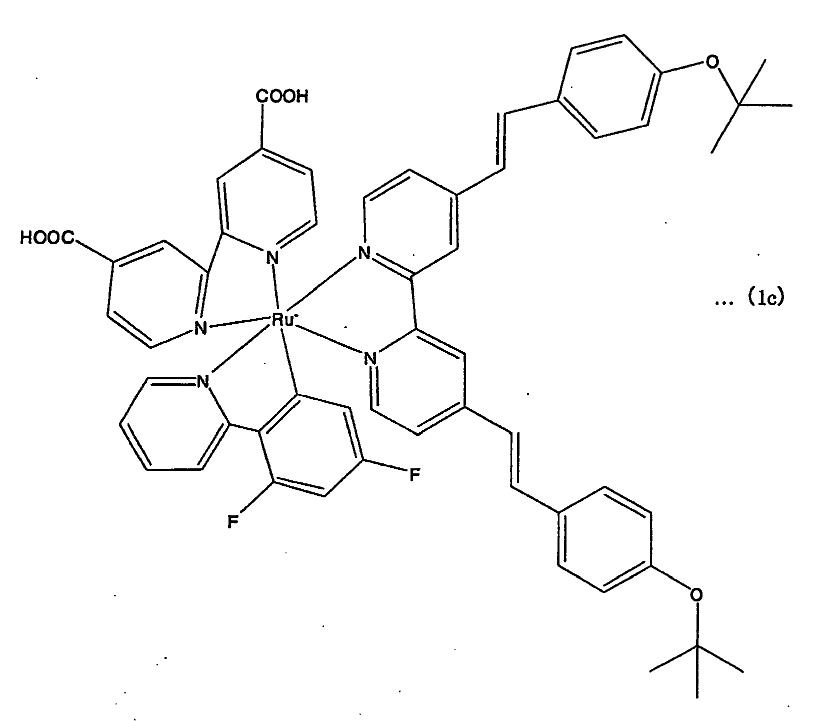

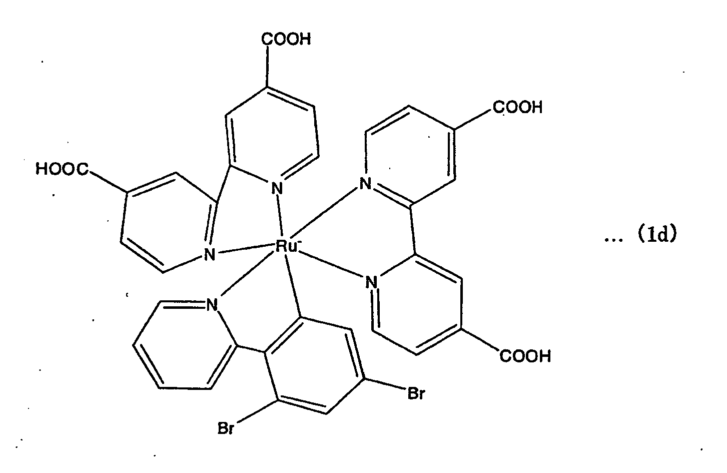

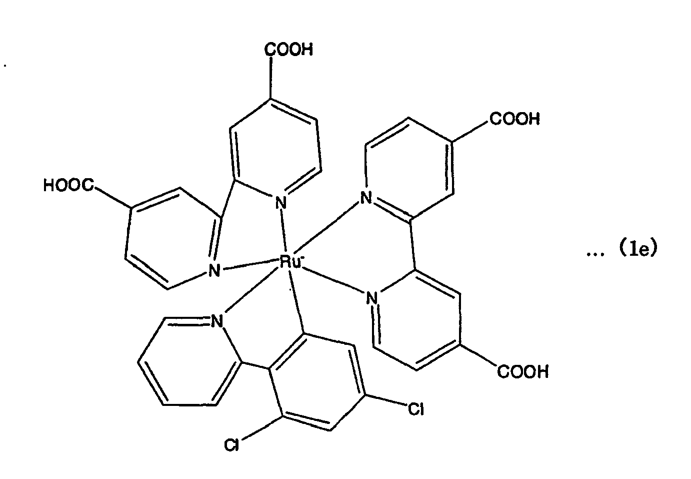

### [1-2] Second embodiment:

A second embodiment of the invention is a dyestuff shown by the following formula (4) (hereinafter referred to from time to time as "second dyestuff').

ML⁴L⁵ (4)

In the formula (4), M is a central atom. The definition, examples of atoms, and preference of the ruthenium atom as described in connection of the formula (2) apply to M in the formula (4).

In the formula (4), L⁴ is a tridentate ligand shown by the following formula (5),

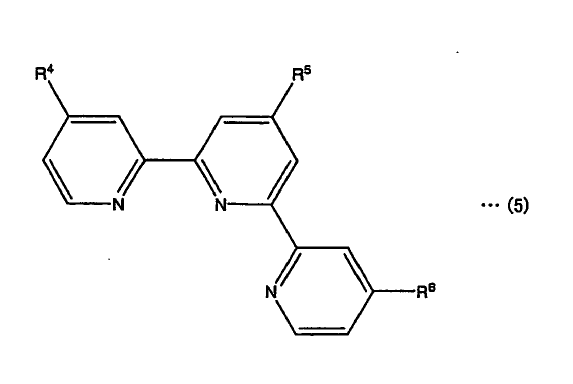

wherein R⁴, R⁵, and R⁶ individually represent a carboxyl group or a group equivalent to a salt of the carboxyl group. As examples of the group equivalent to a salt of the carboxyl group, the same group as given in connection with the formula (2) can be given. As examples of the carboxyalkyl group, a carboxymethyl group and the like can be given.

In the formula (4), L⁵ is a tridentate ligand shown by the following formulas (6) to (8), 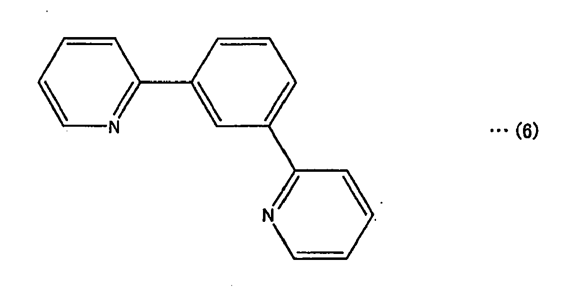 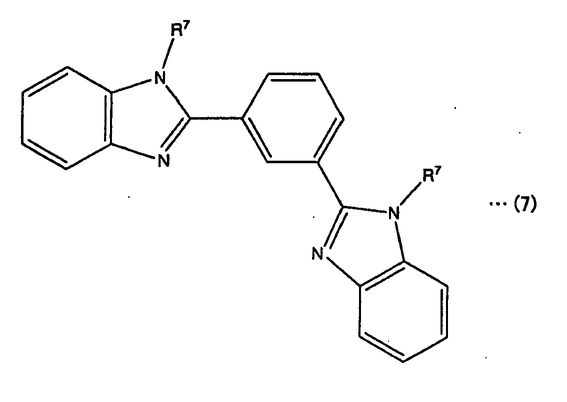 wherein R⁷ individually represents a hydrocarbon group having 1 to 8 carbon atoms,

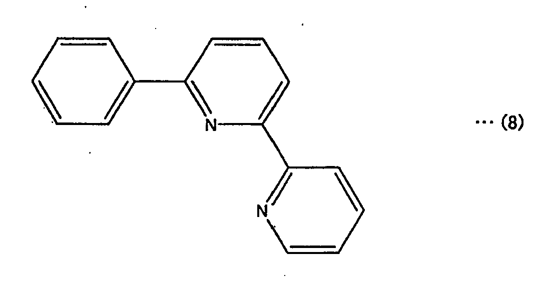

In the formula (7), R⁷ individually represents a hydrocarbon group having 1 to 8 carbon atoms. As examples of the hydrocarbon group having 1 to 8 carbon atoms, an n-butyl group and the like can be given.

### [1-3] Third embodiment:

A third embodiment of the invention is a dyestuff shown by the following formula (9) (hereinafter referred to from time to time as "third dyestuff"),

ML³L⁴A¹ (9)

In the formula (9), M is a central atom. The definition, examples of atoms, and preference of the ruthenium atom as described in connection of the formula (2) apply to M in the formula (9).

L³ represents a bidentate ligand which was described in the formula (3) of the first embodiment, and L⁴ represents a tridentate ligand which was described in the formula (5) of the second embodiment. The same definition and examples of substituents mentioned in the second embodiment apply to R⁴, R⁵, and R⁶ of the formula (5). A¹ is an isothiocyanate group (-NCS).

As an specific example of the dyestuff of the third embodiment, a dyestuff shown by the following formula (9a) can be given.

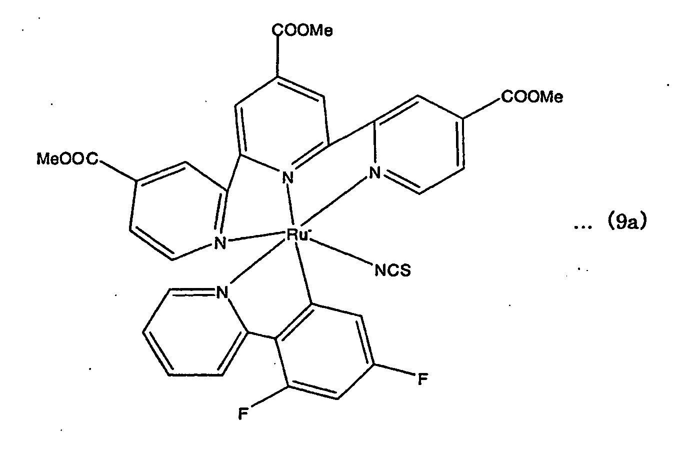

### [2] Dye-sensitized solar cell:

The dye-sensitized solar cell of the present invention is equipped with an anode, a cathode, and an electrolyte. The cathode has a substrate made of electrically conductive transparent glass and an oxide membrane electrode formed on the surface, and the oxide membrane electrode contains the dye described above adsorbed therein.

There are no limitations to the material of the anode insofar as the anode is formed from a material having conductivity. For example, a substrate made of electrically conductive transparent glass which contains a small amount of platinum or conductive carbon adhering to the surface can be suitably used. As the electrically conductive transparent glass, a glass made of tin oxide, indium-tin oxide (ITO), or the like can be used.

The cathode has a substrate made of electrically conductive transparent glass and an oxide membrane electrode formed on the surface, and the oxide membrane electrode contains the dye described above adsorbed therein. As the electrically conductive transparent glass, a glass made of the material described in connection with the anode can be used. The shape of the substrate is not particularly limited. For example, a substrate in the form of a plate and the like may be used.

As the oxide forming the oxide membrane electrode, a metal oxide such as titanium oxide, niobium oxide, zinc oxide, tin oxide, tungsten oxide, and indium oxide can be given. Of these oxides, titanium oxide, niobium oxide, and tin oxide are preferable, with titanium oxide being particularly preferable. The oxide membrane electrode adsorbing the dyestuff of the present invention is used. A method for adsorption will be discussed in the description of the manufacturing method.

As the electrolyte, a liquid electrolyte, a solid electrolyte, or a solution containing the electrolyte can be used. A redox electrolyte is particularly preferable. The redox electrolyte refers to a solution containing a substance forming a redox system (oxidizing agent and reducing agent). For example, a solution containing iodine and imidazolium salt of iodine, which forms a redox system (I/I₃ system) shown in the following formula (15), can be suitably used. An electrochemically inert substance, for example, acetonitrile or propionitrile, can be suitably used as the solvent for the solution.

I₃⁻ + 2e⁻ ←→ 3I· + I₂ (15)

The dye-sensitized solar cell may be fabricated so that the electrolyte may fill the space between the anode and cathode. For example, after filling an electrolytic solution in a container, the anode and cathode may be disposed face to face in the electrolytic solution.

### [3] Method for manufacturing dye-sensitized solar cell:

The method for manufacturing the dye-sensitized solar cell of the present invention comprises causing a substrate made of electrically conductive transparent glass and a cathode having an oxide membrane electrode formed on the surface to come in contact with the dyestuff solution of the present invention, thereby causing the dyestuff to be adsorbed in the oxide membrane electrode.

### [3-1] Formation of oxide membrane electrode:

The manufacturing method of the present invention thus comprises a step of causing the dyestuff to be adsorbed in an oxide membrane electrode which constitutes the cathode. The oxide membrane electrode must be provided prior to adsorption of the dyestuff. There are no specific limitations to the method for forming the oxide membrane electrode. For example, the oxide membrane electrode can be formed by suspending fine particles of an oxide in a suitable dispersion medium to obtain an oxide slurry, applying the slurry to the surface of the substrate of electrically conductive transparent glass, removing the solvent, and heating the resulting coating.

### [3-2] Adsorption of dyestuff:

The dyestuff of the present invention is caused to be adsorbed in the oxide membrane electrode. The dyestuff is adsorbed by causing the substrate of electrically conductive transparent glass and the cathode having an oxide membrane electrode formed on the surface to come in contact with a dyestuff solution containing the dyestuff of the present invention and a base.

The dyestuff solution is a solution containing the dyestuff of the present invention, that is, the dyestuff of any one of the above formula (1), (4), or (9). The dyestuff solution preferably contains the dyestuff of the present invention at a concentration of 0.1 to 10 mmol/l. The concentration of the dyestuff at 0.1 mmol/l or more ensures sufficient adsorption of the dyestuff by the oxide membrane electrode. On the other hand, controlling the dyestuff concentration to 10 mmol/l or less inhibits adsorption of dyestuff molecules among themselves. In order to surely exhibit the above-mentioned effects, a more preferable dye concentration is in a range of 0.2 to 5 mmol/l, with a particularly preferable concentration being in a range of 0.5 to 2 mmol/l.

The dye solution contains a base in addition to the dyestuff of the present invention. The base is either an inorganic base or an organic base.

As examples of the inorganic base, a hydroxide of an alkali metal, carbonate of an alkali metal, sulfide of an alkali metal, and hydroxide of an alkaline earth metal can be given.

As examples of the hydroxide of an alkali metal, lithium hydroxide, sodium hydroxide, and potassium hydroxide can be given; as examples of the carbonate of an alkali metal, lithium carbonate, sodium carbonate, and potassium carbonate can be given; as examples of the sulfide of an alkali metal, lithium sulfide, sodium sulfide, and potassium sulfide can be given; and as examples of the hydroxide of an alkaline earth metal, calcium hydroxide and magnesium hydroxide can be given.

As the organic base, primary to tertiary amine compounds, a hydroxide of quaternary ammonium, carbonate of quaternary ammonium, sulfide of quaternary ammonium, hydroxide of quaternary phosphonium, carbonate of quaternary phosphonium, sulfide of quaternary phosphonium, nitrogen-containing hetero aromatic compounds having a nitrogen atom in an aromatic ring, aromatic amine compounds, and the like can be given.

As examples of the primary to tertiary amine compounds, primary amines such as methylamine and ethylamine; secondary amines such as dimethylamine and diethylamine; and tertiary amines such as trimethylamine and triethylamine can be given.

As examples of the hydroxide of quaternary ammonium, tetraethylammonium hydroxide and tetrabutylammonium hydroxide can be given; as examples of the carbonate of quaternary ammonium, tetramethylammonium carbonate and tetrabutylammonium carbonatecan be given; and, as examples of the sulfide of quaternary ammonium, tetramethylammonium sulfate and tetrabutylammonium sulfate can be given.

As examples of the hydroxide of quaternary phosphonium, tetramethylphosphonium hydroxide and tetrabutylphosphonium hydroxide can be given; as examples of the carbonate of quaternary phosphonium, tetramethylphosphonium carbonate and tetrabutylphosphonium carbonate can be given; and as examples of the sulfide of quaternary phosphonium, tetramethylphosphonium sulfate and tetrabutylphosphonium sulfate can be given.

As examples of the nitrogen-containing hetero aromatic compound, pyridine, pyrrole, and lutidine can be given; and as examples of the aromatic amine compounds, aniline, methylaniline, and dimethylaniline can be given.

In the production process of the present invention, use of a Broensted base among the above-mentioned bases is preferable. Use of an organic base is more preferable, and use of a hydroxide of quaternary ammonium and carbonate of quaternary ammonium is still more preferable. Particularly preferable bases are tetraethylammonium hydroxide, tetrabutylammonium hydroxide, tetramethylammonium carbonate, and tetrabutylammonium carbonate; with tetraethylammonium hydroxide and tetrabutylammonium hydroxide being the most preferable.

The dyestuff solution contains the base at a concentration preferably of 0.0001 to 50 mN, more preferably 0.001 to 20 mN, and still more preferably 0.01 to 10 mN.

As the solvent used for the dyestuff solution, water, a polar organic solvent, or a mixture of these is preferably used. As the polar organic solvent, ethers, alcohols, nitriles, amides, sulfoxides, and the like can be given.

As examples of the ethers, diethyl ether, ethylene glycol dimethyl ether, and ethylene glycol diethyl ether can be given; as examples of the alcohols, ethanol, methanol, isopropyl alcohol, and butanol can be given; as examples of the nitriles, acetonitrile, benzonitrile, and propiononitrile can be given; as examples of the amides, dimethylformamide and dimethylacetamide can be given; and as examples of the sulfoxides, dimethylsulfoxide and the like can be given.

Among these solvents, an alcohol, a nitrile, or an amide is preferable in the manufacturing method of the present invention, with ethanol, methanol, butanol, or acetonitrile being more preferable. As mixed solvents of these solvents, a mixture of an alcohol and a nitrile is preferable, with a mixture of butanol and acetonitrile being more preferable.

Although the method of causing the cathode to come in contact with the dyestuff solution is not specifically limited, a method of dipping the cathode into the dyestuff solution and causing the dyestuff to be adsorbed in the oxide membrane electrode is preferably used.

The dipping time is preferably from 0.5 to 100 hours, more preferably from 2 to 50 hours, and particularly preferably from 12 to 24 hours.

The dipping temperature is in a range of 0 to 100°C, and more preferably 10 to 50°C

### [3-3] Formation of cell:

The dye-sensitized solar cell can be formed by, for example, filling a container with the electrolytic solution and disposing the anode and cathode face to face in the electrolytic solution. The anode and the cathode can be thus disposed with a desired distance between them by securing them by sandwiching a spacer between them. When a solid electrolyte is used as an electrolyte, the anode and the cathode can also be face to face disposed with a desired distance between them by stacking the cathode, the solid electrolyte, and the anode in that order.

### EXAMPLES

### [Synthesis of dyestuff]

### (Example 1)

A dyestuff shown by the following formula (16) (hereinafter referred to as "Dyestuff T1") was prepared.

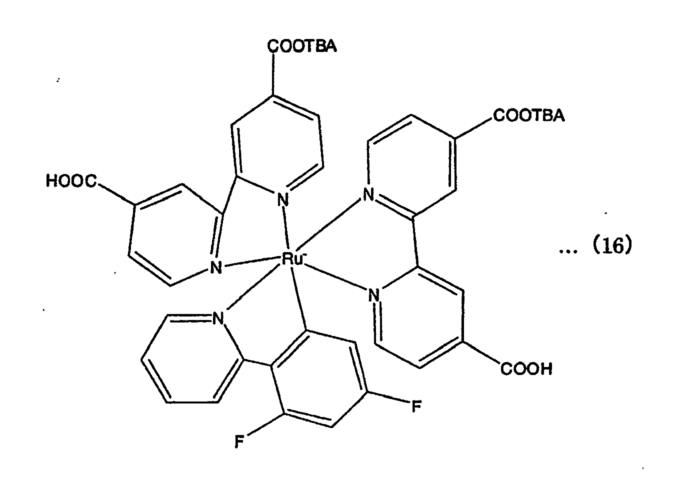

520 mg of ruthenium trichloride and 950 mg of 4,4'-dicarboxy-2,2'-bipyridine, which had been dried under reduced pressure, were added to 5 ml of anhydrous N,N-dimethylformamide, which had been deaerated under reduced pressure and placed in a nitrogen atmosphere in advance. The solution was allowed to stand in a nitrogen gas stream for 10 minutes. The solution was reacted at 200°C under a nitrogen atmosphere for five hours while stirring. The reaction solution was then allowed to stand to cool to room temperature and the solvent was evaporated under reduced pressure. 1 ml of 2N hydrochloric acid and 10 ml of water were added to the resulting concentrate and the mixture was stirred at room temperature to precipitate the reaction product. The precipitate was collected by filtration to obtain 500 mg of a product (the product is hereinafter referred to as "D1").

100 mg of D1 and 59 mg of 2-(2,4-difluorophenyl)pyridine, which had been previously dried under reduced pressure, were added to 15 ml of ethylene glycol, which had been deaerated under reduced pressure and placed in a nitrogen atmosphere in advance. The solution was allowed to stand in a nitrogen gas stream for 10 minutes. The solution was reacted at 160°C for two hours under a nitrogen atmosphere while stirring. 600 mg of tetrabutylammonium hydroxide was added to the reaction solution, and the resulting mixture was continuously stirred and reacted at 160°C for four hours under a nitrogen atmosphere.

After the reaction, the reaction solution was allowed to cool to room temperature and 50 ml of diethyl ether and 15 ml methanol were added to precipitate a reaction product. After allowing to stand overnight, the precipitate was collected by filtration, dissolved in a small amount of methanol, and purified using column chromatography to obtain 60 mg of a product. As a column for purification, "Sephadex LH-20" (manufactured by Amersham Biosciences) was used. The purified product was analyzed by ¹H-NMR to confirm it to be Dyestuff T1 of the above-described formula (16).
[¹H-NMR (CD₃OD, 400 MHz, δ (ppm)); δ = 9.05(4H), 8.32(1H), 8.12(1H), 7.90(4H), 7.77(4H), 7.58(1H), 7.00(1H), 6.42(1H), 5.85(1H)]

### (Example 2)

A dyestuff shown by the following formula (17) (hereinafter referred to as "Dyestuff T2") was prepared.

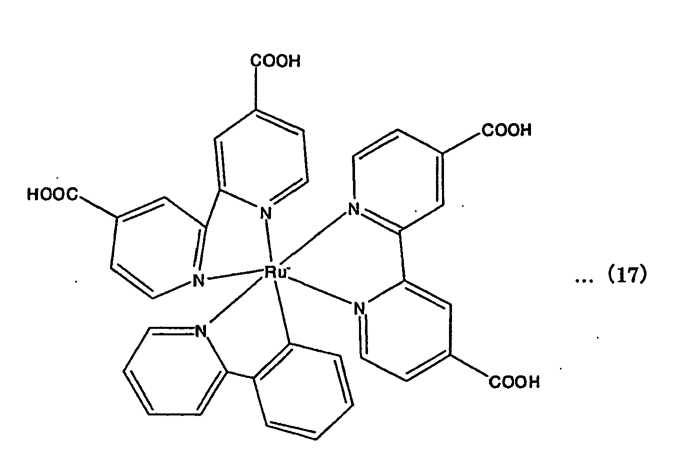

75 mg of D1 synthesized in Example 1 and 40 mg of 2-phenylpyridine, which had been previously dried under reduced pressure, were added to 12 ml of ethylene glycol, which had been previously deaerated under reduced pressure and placed in a nitrogen atmosphere. The solution was allowed to stand in a nitrogen gas stream for 10 minutes. The solution was reacted at 160°C for two hours under a nitrogen atmosphere while stirring. 460 mg of tetrabutylammonium hydroxide was added to the reaction solution, and the resulting mixture was continuously stirred and heated at 160°C for four hours under a nitrogen atmosphere.

After the reaction, the reaction solution was allowed to cool to room temperature and 50 ml of diethyl ether and 15 ml methanol were added to precipitate a reaction product. After allowing to stand overnight, the precipitate was collected by filtration and treated in the same manner as in Example 1 to obtain 60 mg of a purified product. The purified product was analyzed by ¹H-NMR to confirm it to be Dyestuff T2 of the above-described formula (17).
[¹H-NMR (CD₃OD, 400MHz, δ (ppm)); δ = 9.07(1H), 9.02(1H), 8.93(1H), 8.88(2H), 8.15(1H), 8.05(1H), 7.90(5H), 7.75(1H), 7.70(1H), 7.64(1H), 7.60(1H), 6.95(1H), 6.90(1H), 6.80(1H),6.40(1M]

### (Example 3)

A dyestuff shown by the following formula (18) (hereinafter referred to as "Dyestuff T3") was prepared.

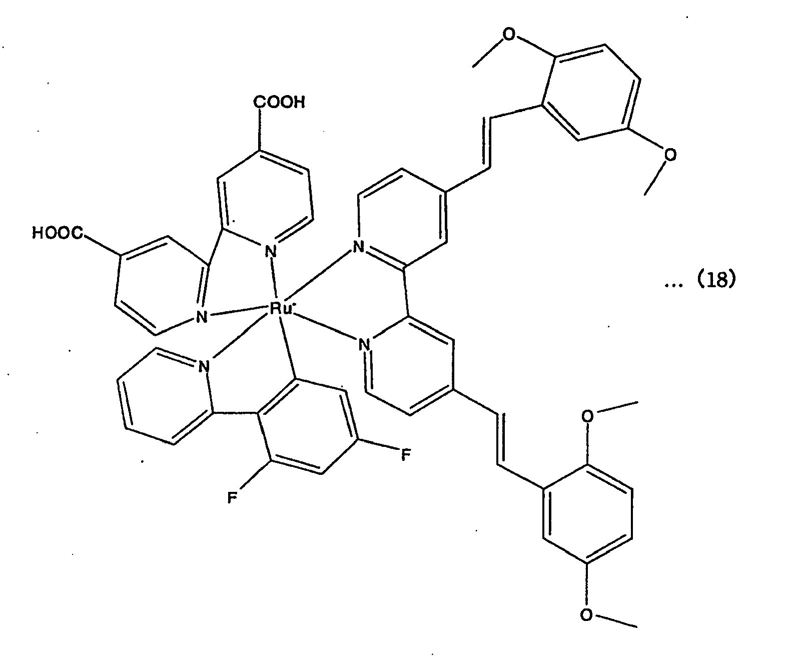

### (1) Synthesis of ligand:

A reaction vessel was charged with a solution of 4.0 g of 4,4'-dimethylpyridine, 10 g of 2,5-dimethoxyformaldehyde, and 10 g of potassium t-butylalkoxide in 240 ml of dimethylformaldehyde. After replacing the atmosphere with nitrogen, the mixture was reacted at room temperature for 24 hours. After the reaction, the solvent was removed, and 400 ml of methanol was added to the residue. The resulting precipitate was collected by filtration to obtain 8.85 g of the target compound.
[¹H-NMR (CDCl₃, 298 K, 400 MHz, δ(ppm)); δ = 8.67(2H), 8.50(2H), 7.50(4H), 7.48(2H), 7.42(2H), 7.40(2H), 7.00(2H), 3.23(6H), 3.05(6H)]

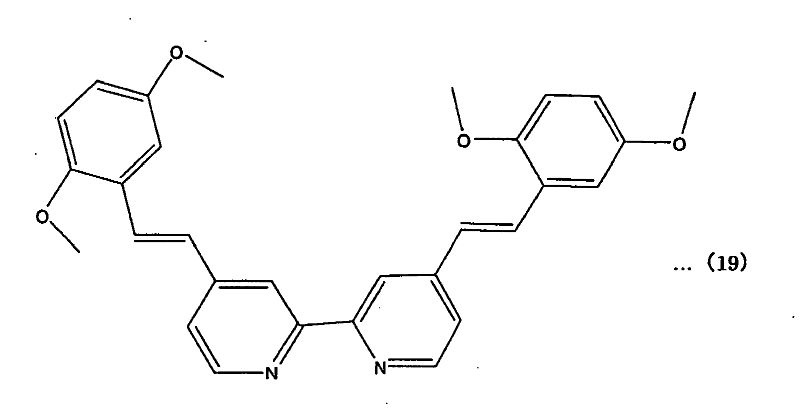

### (2) Synthesis of dyestuff:

100 mg of (p-cymene)ruthenium (II) dichloride and 148 mg of the compound of the above formula (19), which had been dried under reduced pressure, were added to 25 ml of anhydrous N,N-dimethylformamide, which had been previously deaerated under reduced pressure and placed in a nitrogen atmosphere. The solution was allowed to stand in a nitrogen gas stream for 10 minutes. The solution was reacted at 100°C for four hours under a nitrogen atmosphere while stirring. 76 mg of 4,4'-dicarboxy-2,2'-bipyridine was added to the reaction solution. The mixture was placed in a nitrogen stream for 10 minutes, followed by stirring at 150°C for four hours under a nitrogen atmosphere to react the mixture.

After the reaction, the reaction solution was allowed to cool to room temperature, and the solvent was removed. 5 ml of N,N-dimethylformamide was added and the solution was added dropwise to 100 ml of water to precipitate a reaction product. 100 mg of the precipitate which was collected by filtration and 42 mg of 2-(2,4-difluorophenyl)pyridine, which had been dried under reduced pressure, were added to 20 ml of ethylene glycol, which had been previously deaerated under reduced pressure and placed in a nitrogen atmosphere. The solution was allowed to stand in a nitrogen gas stream for 10 minutes. The solution was reacted at 160°C for two hours while stirring under a nitrogen atmosphere. 266 mg of tetrabutylammonium hydroxide was added to the reaction solution, and the resulting mixture was reacted at 160°C for four hours under a nitrogen atmosphere.

After the reaction, the reaction solution was allowed to cool to room temperature. 0.1 N nitric acid was added dropwise to adjust the pH to 5.0, and 50 ml of diethyl ether and 15 ml methanol were added to precipitate a reaction product. After allowing to stand overnight, the precipitate was collected by filtration and treated in the same manner as in Example 1 to obtain 55 mg of a purified product. The purified product was analyzed by ¹H-NMR to confirm it to be Dyestuff T3 of the above-described formula (18).
[¹H-NMR (CD₃OD, 400 MHz, δ(ppm)); δ = 9.05(1H), 8.95(1H), 8.60(2H), 8.30(2H), 8.10(1H), 7.90(1H), 7.85(1H), 7.80(1H), 7.78(1H), 7.68(1H), 7.62(1H), 7.58(2H), 7.40(1H), 7.38(2H), 7.25(2H), 7.00(1H), 6.85(4H), 6.10(1H), 3.25(3H), 3.24(1H), 3.22(3H), 3.19(3H)]

### (Example 4).

A dyestuff shown by the following formula (20) (hereinafter referred to as "Dyestuff T4") was prepared.

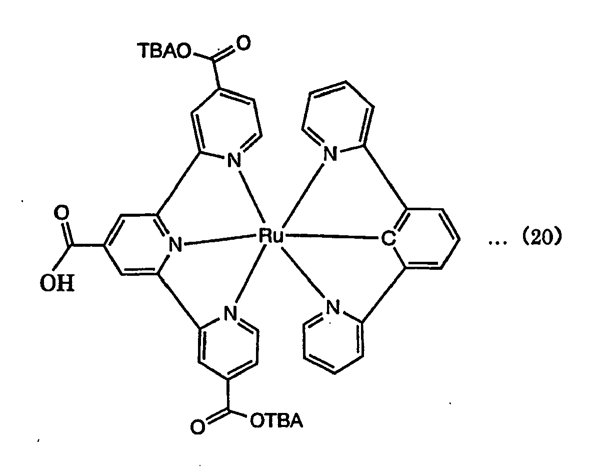

300 mg of ruthenium trichloride and 500 mg of 4,4',4""-tricarboxy-2,2',2"-terpyridine, which had been dried under reduced pressure, were added to 5 ml of anhydrous N,N-dimethylformamide, which had been previously deaerated under reduced pressure and placed in a nitrogen atmosphere. The solution was allowed to stand in a nitrogen gas stream for 10 minutes. The solution was reacted at 200°C under a nitrogen atmosphere for five hours while stirring. The reaction solution was then allowed to stand to cool to room temperature and the solvent was evaporated under reduced pressure. 1 ml of 2N hydrochloric acid and 10 ml of water were added to the resulting concentrate and the mixture was stirred at room temperature to precipitate the reaction product. The precipitate was collected by filtration to obtain 350 mg of a product (this product is hereinafter referred to as "D2").

100 mg of D2 and 150 mg of 2,6-di(2-pyridyl)benzene, which had been previously dried under reduced pressure, were added to 20 ml of ethylene glycol, which had been previously deaerated under reduced pressure and placed in a nitrogen atmosphere. The solution was allowed to stand in a nitrogen gas stream for 10 minutes. The solution was reacted at 160°C for two hours under a nitrogen atmosphere while stirring. 400 mg of tetrabutylammonium hydroxide was added to the reaction solution, and the resulting mixture was continuously stirred and reacted at 160°C for four hours under a nitrogen atmosphere.

After the reaction, the reaction solution was allowed to cool to room temperature. The ethylene glycol was evaporated under reduced pressure. After the addition of 20 ml of distilled water, 0.15 N nitric acid was added dropwise to adjust the pH to 3.0 to precipitate a reaction product. After allowing to stand overnight, the precipitate was collected by filtration and treated in the same manner as in Example 1 to obtain 120 mg of a purified product. The purified product was analyzed by ¹H-NMR to confirm it to be Dyestuff T4 of the above-described formula (20).
[¹H-NMR(CD₃OD, 400 MHz, δ(ppm)); δ = 9.05(1H), 8.92(1H), 8.88(1H), 8.58(2H), 8.10(1H), 7.65(1H), 7.55(1H), 7.52(1H), 7.46(1H), 7.32(1H), 7.22(1H), 7.21(2H), 7.15(2H), 7.12(1H), 6.85(1H), 6.10(1H)]

### (Example 5)

A dyestuff shown by the following formula (21) (hereinafter referred to as "Dyestuff T5") was prepared.

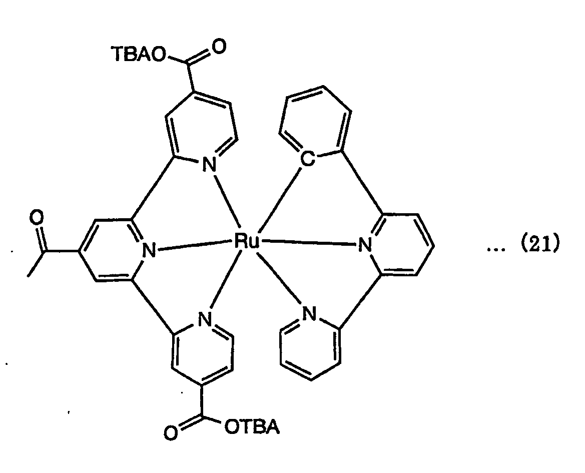

100 mg of D2 and 150 mg of 2-(2-pyridyl)-6-phenylpyridine, which had been dried under reduced pressure, were added to 20 ml of ethylene glycol, which had been previously deaerated under reduced pressure and placed in a nitrogen atmosphere. The solution was allowed to stand in a nitrogen gas stream for 10 minutes. The solution was reacted at 160°C for two hours under a nitrogen atmosphere while stirring. 400 mg of tetrabutylammonium hydroxide was added to the reaction solution, and the resulting mixture was continuously stirred and reacted at 160°C for four hours under a nitrogen atmosphere.

After the reaction, the reaction solution was allowed to cool to room temperature. The ethylene glycol was evaporated under reduced pressure. After the addition of 20 ml of distilled water, 0.15 N nitric acid was added dropwise to adjust the pH to 3.0 to precipitate a reaction product. After allowing to stand overnight, the precipitate was collected by filtration and treated in the same manner as in Example 1 to obtain 80 mg of a purified product. The purified product was analyzed by ¹H-NMR to confirm it to be Dyestuff T5 of the above-described formula (21).
[¹H-NMR (CD₃OD, 400 MHz, δ (ppm)); δ = 9.03(1H), 8.90(2H), 8.58(2H), 8.10(1H), 7.65(1H), 7.55(1H), 7.52(1H), 7.46(1H), 7.32(1H), 7.25(2H), 7.21(3H), 6.99(1H), 6.91(1H), 6.30(1H)]

### (Example 6)

A dyestuff shown by the following formula (22) (hereinafter referred to as "Dyestuff T6") was prepared.

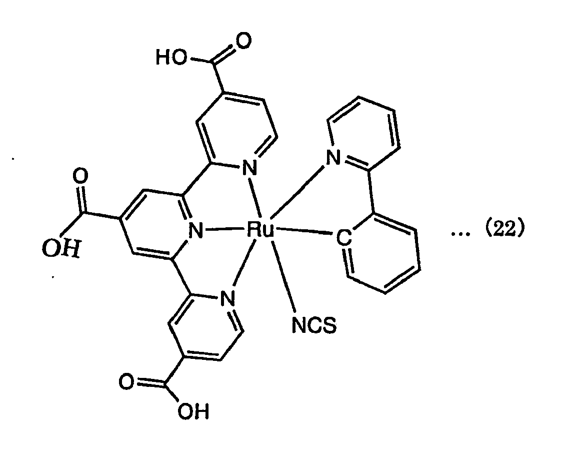

100 mg of D2 and 150 mg of 2-phenylpiridine, which had been dried under reduced pressure, were added to 20 ml of ethylene glycol, which had been previously deaerated under reduced pressure and placed in a nitrogen atmosphere. The solution was allowed to stand in a nitrogen gas stream for 10 minutes. The solution was reacted at 160°C for two hours under a nitrogen atmosphere while stirring. 400 mg of tetrabutylammonium hydroxide was added to the reaction solution, and the resulting mixture was continuously stirred and reacted at 160°C for four hours under a nitrogen atmosphere. 250 mg of potassium thiocyanate was further added to the reaction solution, and the resulting mixture was continuously stirred and reacted at 160°C for four hours under a nitrogen atmosphere.

After the reaction, the reaction solution was allowed to cool to room temperature. The ethylene glycol was evaporated under reduced pressure. After the addition of 20 ml of distilled water, 0.15 N nitric acid was added dropwise to adjust the pH to 3.0 to precipitate a reaction product. After allowing to stand overnight, the precipitate was collected by filtration and treated in the same manner as in Example 1 to obtain 100 mg of a purified product. The purified product was analyzed by ¹H-NMR to confirm it to be Dyestuff T6 of the above-described formula (22).
[¹H-NMR (CD₃OD, 400 MHz, δ (ppm)); δ = 9.03(1H), 8.88(2H), 8.48(2H), 8.10(1H), 7.65(1H), 7.35(1H), 7.32(1H), 7.20(2H), 7.15(2H), 6.80(1H), 6.50(1H), 6.30(1H)]

### (Example 7)

A dyestuff shown by the following formula (23) (hereinafter referred to as "Dyestuff T7") was prepared.

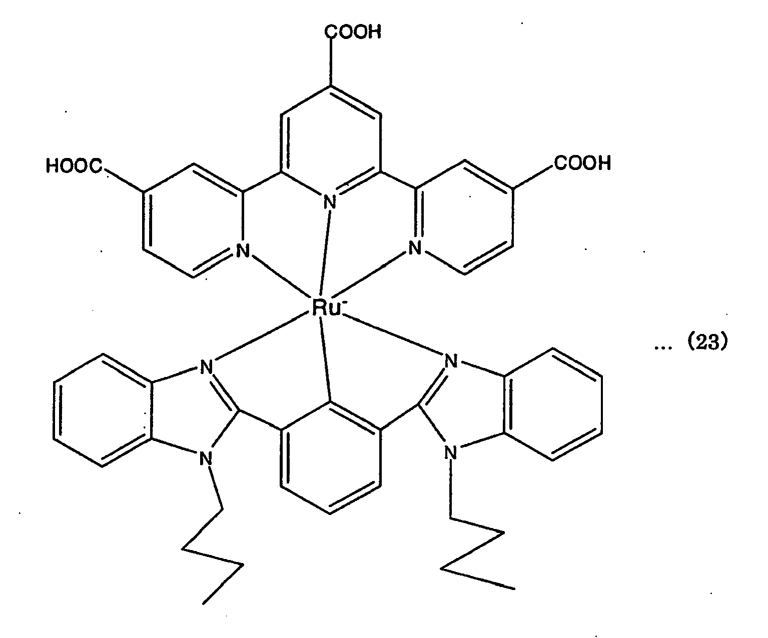

100 mg of D2 and 150 mg of 2,6-(N,N'-butylimidazolyl)benzene, which had been dried under reduced pressure, were added to 20 ml of ethylene glycol, which had been previously deaerated under reduced pressure and placed in a nitrogen atmosphere. The solution was allowed to stand in a nitrogen gas stream for 10 minutes. The solution was reacted at 160°C for two hours under a nitrogen atmosphere while stirring. 400 mg of tetrabutylammonium hydroxide was added to the reaction solution, and the resulting mixture was continuously stirred and reacted at 160°C for four hours under a nitrogen atmosphere.

After the reaction, the reaction solution was allowed to cool to room temperature. The ethylene glycol was evaporated under reduced pressure. After the addition of 20 ml of distilled water, 0.15 N nitric acid was added dropwise to adjust the pH to 3.0 to precipitate a reaction product. After allowing to stand overnight, the precipitate was collected by filtration and treated in the same manner as in Example 1 to obtain 80 mg of a purified product. The purified product was analyzed by ¹H-NMR to confirm it to be Dyestuff T7 of the above-described formula (23).
[¹H-NMR (CD₃OD, 400 MHz, δ (ppm)); δ = 9.03(1H), 8.90(2H), 8.88(2H), 8.85(1H), 8.55(1H), 8.48(1H), 8.26(1H), 7.85(2H), 7.80(2H), 7.78(2H), 7.65(2H), 5.45(1H), 5.30(1H), 3.23(4H), 1.86(4H), 1.78(4H), 1.53(6H)]

### [Production of dye-sensitized solar cell]

### (1) Preparation of anode:

An anode was obtained by sintering platinum on the surface of an electrically conductive transparent glass substrate (thickness: 4 mm, tin oxide, resistance = 10 Ohm/cm²).

### (2) Preparation of oxide membrane electrode:

12 g of fine particles of titanium oxide and 0.2 g of a dispersant ("Triton X-100" manufactured by Aldrich) were added to a mixed solvent of 0.4 ml of acetylacetone and 20 ml of ion exchanged water to obtain an oxide slurry. The oxide slurry was applied to the surface of the same electrically conductive transparent glass substrate as used for the preparation of the anode and heated in air at 500°C for 0.5 hours to obtain a titanium oxide membrane electrode on the surface of the same electrically conductive transparent glass substrate.

### (3) Preparation of dye solution:

The dyestuffs T1 to T7 prepared in Examples 1 to 7 and a base were dissolved in ethanol to obtain dye solutions each having a dye concentration of 0.5 mmol/I. As Comparative Example 1, a commercially available dye "N719" was dissolved in ethanol to prepare a dye solution with a dye concentration of 0.5 mmol/l.

### (4) Preparation of cathode:

The above-mentioned substrate on which the oxide membrane electrode was formed was dipped in the above-mentioned dye solution at 23°C for 24 hours to cause the dyestuff to be adsorbed on the oxide membrane electrode, thereby obtaining a cathode.

### (5) Preparation of electrolytic solution:

An electrolytic solution was prepared by dissolving guanidinum thiocyanate, iodine, 1-butyl-3-methylimidazolium iodonium salt, and t-butylpyridine in a mixed solvent of acetonitrile and valeronitrile (volume ratio: 85:15) at concentrations, respectively of 0.1 mol/l, 0.03 mol/l, 0.6 mol/l, and 0.5 mol/l. The electrolytic solution is hereinafter referred to as "electrolytic solution E1".

An electrolytic solution was prepared by dissolving lithium iodonium salt, iodine, and 1-butyl-3-methylimidazolium iodonium salt in a mixed solvent of acetonitrile and valeronitrile (volume ratio: 85:15) at concentrations, respectively of 0.1 mol/l, 0.05 mol/l, 0.6 mol/l. The electrolytic solution is hereinafter referred to as "electrolytic solution E2".

A solution was prepared by dissolving guanidinum thiocyanate, iodine, 1-metyl-3-propylimidazolium iodonium salt, and N-butylbenzimidazole in 3-methoxypropionitrile at concentrations, respectively of 0.1 mol/l, 0.15 mol/l, 1.0 mol/l, and 0.5 mol/l. The solution is hereinafter referred to as "solution E3".

### (6) Preparation of dye-sensitized solar cell:

Dye-sensitized solar cells (Examples 8 to 19 and Comparative Examples 2 and 3) were prepared disposing the cathodes and anodes in containers at intervals of 25 micrometers so that the platinum-sintered side of the anode and the oxide membrane electrode-formed side of the cathode may lie face to face, and filling the electrolytic solution E1, electrolytic solution E2, or solution E into the containers.

### [Evaluation of dye-sensitized solar cell]

### (1) Conversion efficiency (power generation efficiency):

The conversion efficiency of the dye-sensitized solar cells of Examples and Comparative Examples was measured by irradiating these dye-sensitized solar cells with false sunlight at an illumination intensity of 100 mW/cm² by using a solar simulator. The cells were evaluated as "Good" if the conversion efficiency was 6% or more, and as "Bad" if the conversion efficiency was less than 6%. The results are shown in Table 1.

**TABLE 1**

| | | Dyestuff | Electrolytic solution | Conversion efficiency | |
|---|---|---|---|---|---|
| | | | | % | Evaluation |
| Example | 8 | T1 | E1 | 10.08 | Good |
| | 9 | T1 | E2 | 10.02 | Good |
| | 10 | T2 | E1 | 9.55 | Good |
| | 11 | T2 | E2 | 9.03 | Good |
| | 12 | T3 | E1 | 8.55 | Good |
| | 13 | T3 | E2 | 8.32 | Good |
| | 14 | T4 | E1 | 8.35 | Good |
| | 15 | T4 | E2 | 8.32 | Good |
| | 16 | T5 | E1 | 8.35 | Good |
| | 17 | T5 | E2 | 8.32 | Good |
| | 18 | T6 | E1 | 8.35 | Good |
| | 19 | T6 | E2 | 8.32 | Good |
| | 20 | T7 | E1 | 8.56 | Good |
| | 21 | T7 | E2 | 8.85 | Good |
| Comparative Example | 2 | N719 | E1 | 8.01 | Good |
| | 3 | N719 | E2 | 9.03 | Good |

As shown in Table 1, the dye-sensitized solar cells of Examples 8 to 21 using the dyestuffs (T1 to T7) of Examples 1 to 7 exhibited high conversion efficiency comparable or higher with respect to the standard dye N719 see Examples 2 and 3.

### (2) Durability:

The dye-sensitized solar cells of Examples and Comparative Examples were allowed to stand under the conditions of 333K and 100mW/cm², and irradiated with false sunlight at an illumination intensity of 100mW/cm² using a solar simulator for 30 days. The initial conversion efficiency and the conversion efficiency after 30 days were measured.

The durability was evaluated by the ratio (percentage) of the conversion efficiency after 30 days (conversion efficiency B) to the initial conversion efficiency (conversion efficiency A). The cells were evaluated as "Good" if this ratio was 60% or more, and as "Bad" if the ratio was less than 60%. In regard to the initial conversion efficiency (conversion efficiency A), the cells were evaluated as "Good" if the conversion efficiency A was 4% or more, and as "Bad" if less than 4%. In regard to the conversion efficiency after 30 days (conversion efficiency B), the cells were evaluated as "Good" if the conversion efficiency B was 2% or more, and as "Bad" if less than 2%. The results are shown in Table 2.

TABLE 2

**TABLE 2**

| | Dyestuff | Electrolytic solution | Conversion effect (initial) | | Conversion effect (after 30 days) | | Durability | |
|---|---|---|---|---|---|---|---|---|
| | | | A (%) | Evaluation | B (%) | Evaluation | B/A (%) | Evaluation |
| Example 22 | T1 | E3 | 4.67 | Good | 3.23 | Good | 69.2 | Good |
| Comparative Example 4 | N719 | E3 | 4.72 | Good | 1.58 | Bad | 33.5 | Bad |

As shown in Table 2, the dye-sensitized solar cell of Example 22 using the dyestuff (T1) of Example 1 exhibited higher durability than the dye-sensitized solar cells of Comparative Example 4 in which the dye "N719" was used. Although not shown in the Table, the dye-sensitized solar cells using the dyestuffs (T2 to T7) also exhibited the same durability of the dye-sensitized solar cells of Example 22, higher than the dye-sensitized cells of Comparative Examples 4 in which the dye "N719" was used.

Since the dye-sensitized solar cell of the present invention exhibits high conversion efficiency and has excellent durability such as excellent weather resistance and heat resistance, it can be suitably used as a next-generation solar cell which replaces silicon-based solar cells. In addition, the dyestuff and the method for manufacturing the dye-sensitized solar cell can be suitably used for manufacturing the dye-sensitized solar cell.

## Claims

1. A dyestuff shown by the following formula (1),
ML¹L³L³ (1)
wherein M represents an element belonging to Group 8 to Group 10 of the long-format Periodic Table, L¹ and L² individually represent a bidentate ligand shown by the following formula (2), and L³ represents a bidentate ligand shown by the following formula (3), 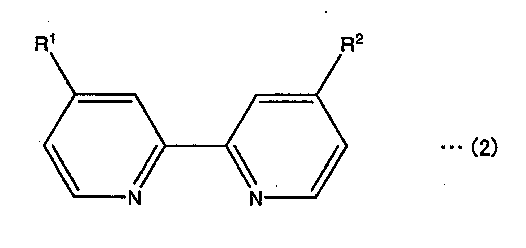 wherein R¹ and R² individually represent a monovalent organic group, and 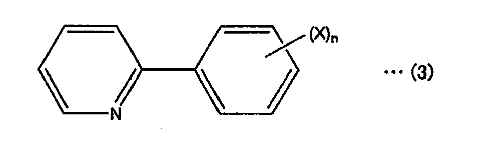 wherein X represents a halogen atom and n is an integer of 0 to 2.

2. A dyestuff shown by the following formula (4),
ML⁴L⁵ (4)
wherein M represents an element belonging to Group 8 to Group 10 of the long-format Periodic Table, L⁴ represents a tridentate ligand shown by the following formula (5), and L⁵ represents a tridentate ligand shown by the following formula (6), (7), or (8), 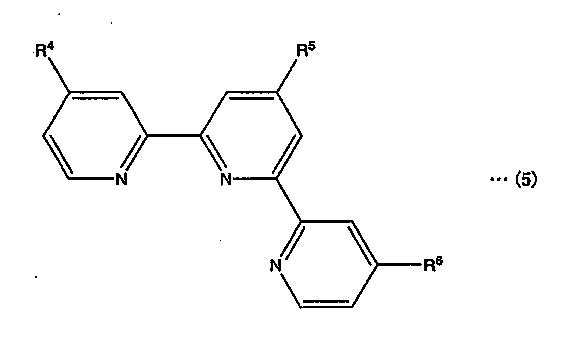 wherein R⁴, R⁵, and R⁶ individually represent a carboxyl group, a group equivalent to the salt of the carboxyl group, or a carboxyalkyl group, 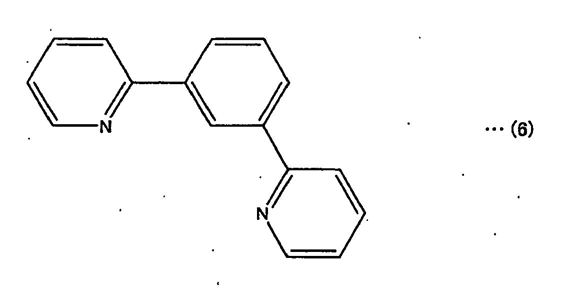 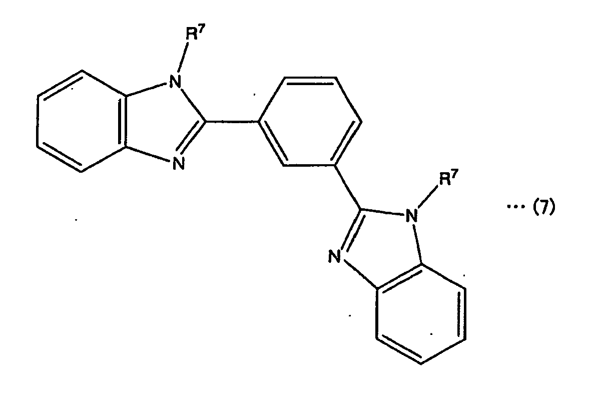 wherein R⁷ individually represents a hydrocarbon group having 1 to 8 carbon atoms.

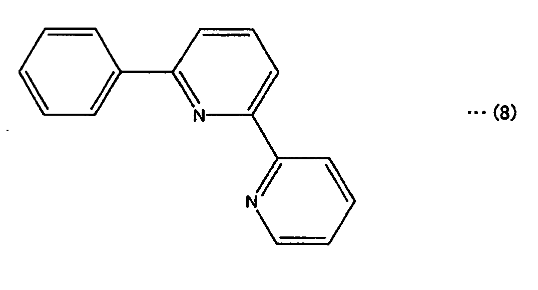

3. A dyestuff shown by the following formula (9),
ML³L⁴A¹ (9)
wherein M represents an element belonging to Group 8 to Group 10 of the long-format Periodic Table, L³ represents a bidentate ligand shown by the following formula (3), L⁴ represents a tridentate ligand shown by the following formula (5), and A¹ is an isothiocyanate group, 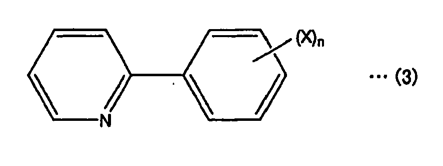 wherein X represents a halogen atom and n is an integer of 0 to 2. 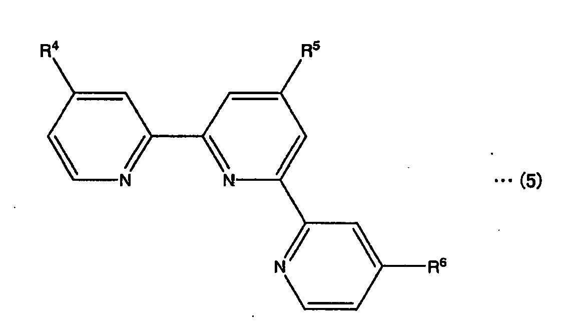 wherein R⁴, R⁵, and R⁶ individually represent a carboxyl group, a group equivalent to the salt of the carboxyl group, or a carboxyalkyl group.

4. The dyestuff according to any one of claims 1 to 3, wherein M in the formula (1), (4), or (9) is ruthenium.

5. A dye-sensitized solar cell comprising an anode, a cathode, and an electrolyte, the cathode having a substrate made of electrically conductive transparent glass and an oxide membrane electrode formed on the surface, and the oxide membrane electrode containing a dye according to any one of claims 1 to 4 adsorbed therein.

6. A method for manufacturing a dye-sensitized solar cell comprising causing a substrate made of electrically conductive transparent glass and a cathode having an oxide membrane electrode formed on the surface to come in contact with a dyestuff solution which contains the dyestuff according to any one of claims 1 to 4 and a base, thereby causing the dyestuff to be adsorbed in the oxide membrane electrode.

7. The method for manufacturing a dye-sensitized solar cell according to claim 6, wherein the dyestuff solution contains the base at a concentration of 0.001 to 20 mmol/l.

## Patentansprüche

1. Farbstoff, der durch die folgende Formel (1) gezeigt ist,
ML¹L²L³ (1)
wobei M ein Element darstellt, das zur Gruppe 8 bis Gruppe 10 des großformatigen Periodensystems gehört, L¹ und L² unabhängig einen bidentalen Liganden darstellen, der durch die folgende Formel (2) gezeigt ist, und L³ einen bidentalen Liganden darstellt, der durch die folgende Formel (3) gezeigt ist, 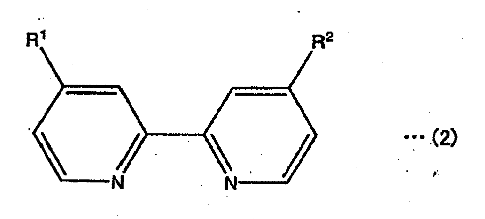 wobei R¹ und R² unabhängig eine einwertige organische Gruppe darstellen, und 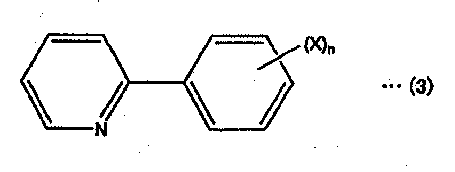 wobei X ein Halogenatom darstellt und n eine ganze Zahl von 0 bis 2 ist.

2. Farbstoff, der durch die vorliegende Formel (4) gezeigt ist,
ML⁴L⁵ (4)
wobei M ein Element darstellt, das zur Gruppe 8 bis Gruppe 10 des großformatigen Periodensystems gehört, L⁴ einen tridentalen Liganden darstellt, der durch die folgende Formel (5) gezeigt ist, und L⁵ einen tridentalen Liganden darstellt, der durch die folgende Formel (6), (7) oder (8) gezeigt ist, 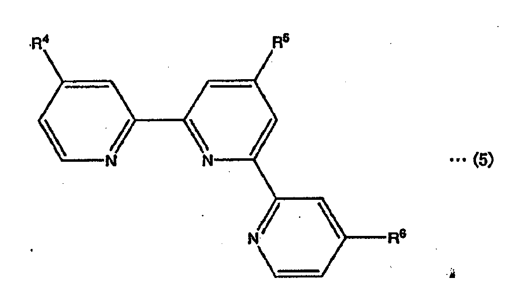 wobei R⁴, R⁵ und R⁶ unabhängig eine Carboxylgruppe, eine Gruppe, die äquivalent zu dem Salz der Carboxylgruppe ist, oder eine Carboxyalkylgruppe darstellen, 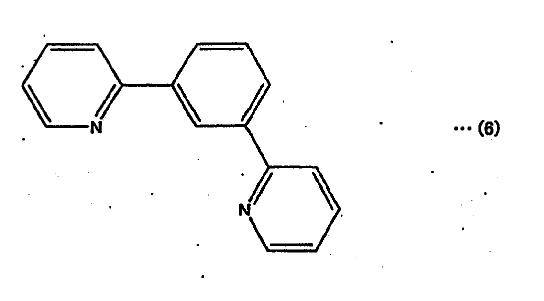 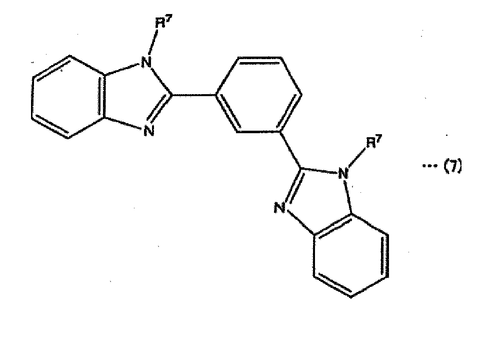 wobei R⁷ unabhängig eine Kohlenwasserstoffgruppe mit 1 bis 8 Kohlenstoffatomen darstellt.

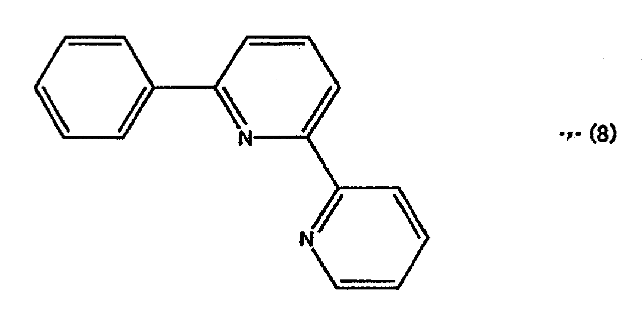

3. Farbstoff, der durch die folgende Formel (9) gezeigt ist,
ML³L⁴A¹
wobei M ein Element darstellt, das zur Gruppe 8 bis Gruppe 10 des großformatigen Periodensystems gehört, L³ einen bidentalen Liganden darstellt, der durch die folgende Formel (3) gezeigt ist, L⁴ einen tridentalen Liganden darstellt, der durch die folgende Formel (5) gezeigt ist, und A¹ eine Isothiocyanatgruppe ist, 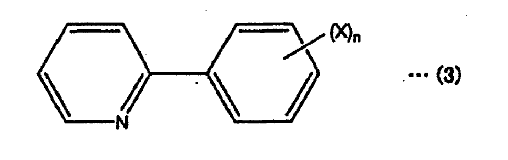 wobei X ein Halogenatom darstellt und n eine ganze Zahl von 0 bis 2 ist, 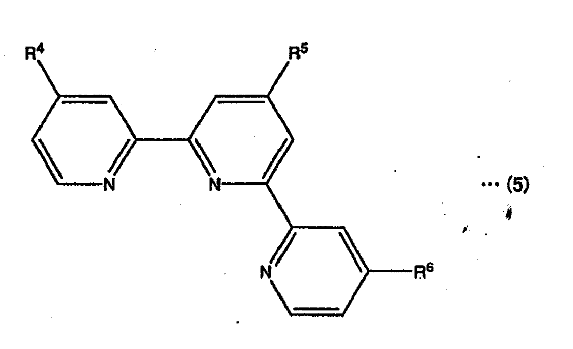 wobei R⁴, R⁵ und R⁶ unabhängig eine Carboxylgruppe, eine Gruppe, die äquivalent zu dem Salz der Carboxylgruppe ist, oder eine Carboxyalkylgruppe darstellen.

4. Farbstoff nach einem der Ansprüche 1 bis 3, wobei M in der Formel (1), (4) oder (9) Ruthenium ist.

5. Färbemittel-sensibilisierte Solarzelle, die eine Anode, eine Kathode, und einen Elektrolyten umfasst, wobei die Kathode ein Substrat, das aus einem elektrisch leitfähigen transparenten Glas gemacht ist, und eine Oxidmembranelektrode, die auf der Oberfläche gebildet ist, aufweist, und die Oxidmembranelektrode darin adsorbiert ein Färbemittel nach einem der Ansprüche 1 bis 4 enthält.

6. Verfahren zur Herstellung einer Färbemittel-sensibilisierten Solarzelle, umfassend das Bewirken, dass ein Substrat, das aus einem elektrisch leitfähigen transparenten Glas gemacht ist, und eine Kathode, die eine Oxidmembranelektrode gebildet auf der Oberfläche aufweist, in Kontakt mit einer Farbstofflösung kommt, welche den Farbstoff nach einem der Ansprüche 1 bis 4 und eine Base enthält, wodurch bewirkt wird, dass der Farbstoff in der Oxidmembranelektrode adsorbiert wird.

7. Verfahren zur Herstellung einer Färbemittel-sensibilisierten Solarzelle nach Anspruch 6, wobei die Farbstofflösung die Base bei einer Konzentration von 0,001 bis 20 mmol/l enthält.

## Revendications

1. Colorant montré par la formule (1) suivante,
ML¹L²L³ (1)
dans laquelle M représente un élément appartenant au Groupe 8 au Groupe 10 du Tableau Périodique au format long, L¹ et L² représentent individuellement un ligand bidentate montré par la formule (2) suivante, et L³ représente un ligand bidentate montré par la formule (3) suivante, 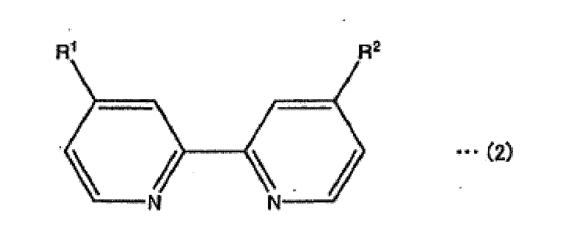 dans laquelle R¹ et R² représentent individuellement un groupe organique monovalent, et 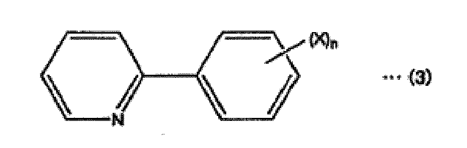 dans laquelle X représente un atome d'halogène et n est un entier de 0 à 2.

2. Colorant montré par la formule (4) suivante,
ML⁴L⁵ (4)
dans laquelle M représente un élément appartenant au Groupe 8 au Groupe 10 du Tableau Périodique au format long, L⁴ représente un ligand tridentate montré par la formule (5) suivante, et L⁵ représente un ligand tridentate montré par la formule (6), (7) ou (8) suivante, 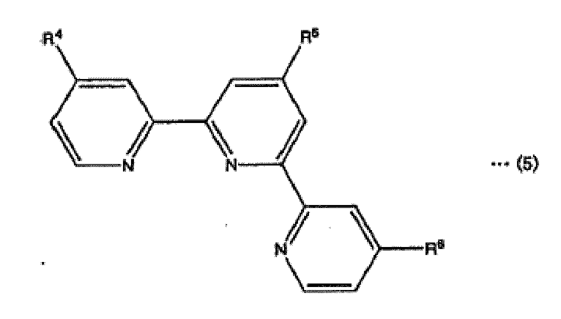 dans laquelle R⁴, R⁵ et R⁶ représentent individuellement un groupe carboxyle, un groupe équivalent au sel du groupe carboxyle, ou un groupe carboxyalkyle, 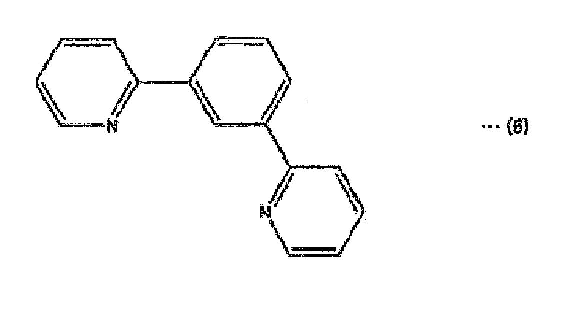 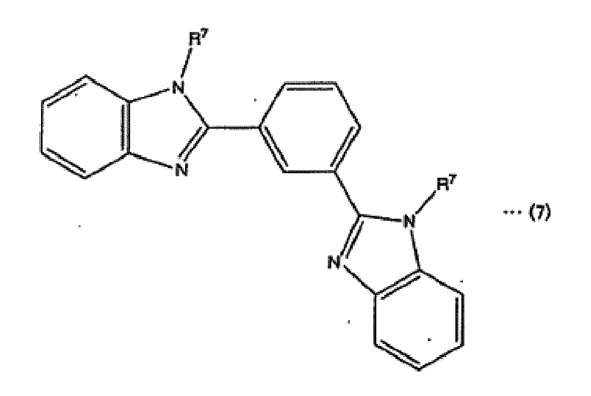 dans laquelle R⁷ représente individuellement un groupe hydrocarbure ayant 1 à 8 atomes de carbone.

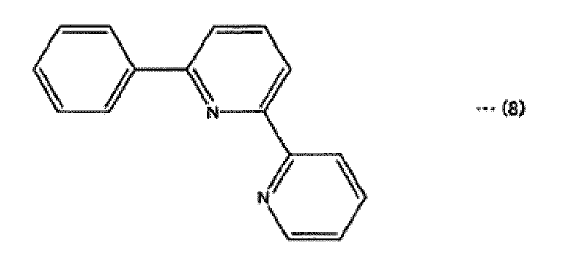

3. Colorant montré par la formule (9) suivante,
ML³L⁴A¹ (9)
dans laquelle M représente un élément appartenant au Groupe 8 au Groupe 10 du Tableau Périodique au format long, L³ représente un ligand bidentate montré par la formule (3) suivante, L⁴ représente un ligand tridentate montré par la formule (5) suivante, et A¹ est un groupe isothiocyanate, 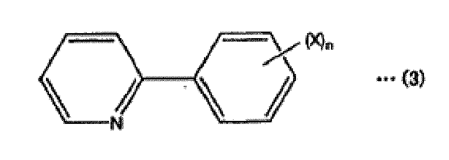 dans laquelle X représente un atome d'halogène et n est un entier de 0 à 2, 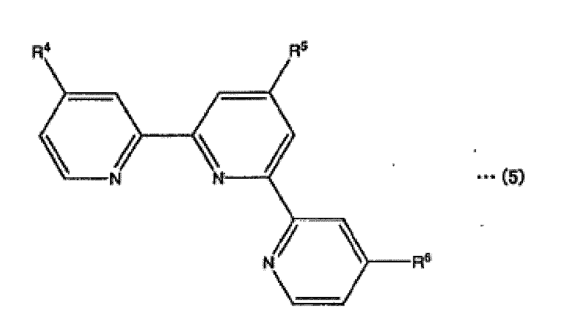 dans laquelle R⁴, R⁵ et R⁶ représentent individuellement un groupe carboxyle, un groupe équivalent au sel du groupe carboxyle, ou un groupe carboxyalkyle.

4. Colorant selon l'une quelconque des revendications 1 à 3, dans lequel M dans la formule (1), (4) ou (9) est le ruthénium.

5. Cellule solaire à pigment photosensible comprenant une anode, une cathode et un électrolyte, la cathode ayant un substrat constitué d'un verre transparent électro-conducteur et une électrode à membrane d'oxyde formée sur la surface, et l'électrode à membrane d'oxyde contenant un colorant selon l'une quelconque des revendications 1 à 4 adsorbé dans celle-ci.

6. Procédé de fabrication d'une cellule solaire à pigment photosensible comprenant la mise d'un substrat constitué d'un verre transparent électro-conducteur et d'une cathode ayant une électrode à membrane d'oxyde formée sur la surface en contact avec une solution de colorant qui contient le colorant selon l'une quelconque des revendications 1 à 4 et une base, faisant ainsi que le colorant est adsorbé dans l'électrode à membrane d'oxyde.

7. Procédé de fabrication d'une cellule solaire à pigment photosensible selon la revendication 6, dans lequel la solution de colorant contient la base à une concentration de 0,001 à 20 mmol/1.
